(19)

Europäisches
Patentamt
European
Patent Office
Office européen
des brevets

(11)    **EP 4 450 991 A1**

(12)    **EUROPEAN PATENT APPLICATION**

(43) Date of publication:
**23.10.2024  Bulletin 2024/43**

(21) Application number: **24166518.1**

(22) Date of filing: **26.03.2024**

(51) International Patent Classification (IPC):
***G01R 31/52*** *(2020.01)*

(52) Cooperative Patent Classification (CPC):
**G01R 31/52;** G01R 31/58

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **21.04.2023  JP 2023070398**

(71) Applicants:
• **Yokogawa Electric Corporation**
**Tokyo 180-8750 (JP)**

• **Yokogawa Test & Measurement Corporation Hachioji-shi, Tokyo 192-8566 (JP)**

(72) Inventors:
• **KENJI, Murakami**
**Hachioji-shi, Tokyo, 192-8566 (JP)**
• **NAOKI, Ito**
**Hachioji-shi, Tokyo, 192-8566 (JP)**

(74) Representative: **Stöckeler, Ferdinand et al**
**Schoppe, Zimmermann, Stöckeler**
**Zinkler, Schenk & Partner mbB**
**Patentanwälte**
**Radlkoferstrasse 2**
**81373 München (DE)**

(54)    **MEASUREMENT METHOD, MEASUREMENT DEVICE, AND MEASUREMENT SYSTEM**

(57)    A measurement method includes acquiring a three-phase leakage current measured by clamping wirings for three (R, S, and T) phases in three-phase different capacity connection, acquiring a single-phase leakage current measured by clamping wirings for two (R and S) phases whose midpoint (N) being grounded, of the three (R, S, and T) phases in the three-phase different capacity connection, calculating, based on the three-phase leakage current and the single-phase leakage current, a resistance component of a leakage current flowing through a wiring for each of the three (R, S, and T) phases in the three-phase different capacity connection, and outputting a measurement result of the resistance component of the leakage current flowing through the wiring for each of the three (R, S, and T) phases in the three-phase different capacity connection.

EP 4 450 991 A1

**Description**

TECHNICAL FIELD

The present disclosure relates to a measurement method, a measurement device, and a measurement system that measure resistance components of leakage currents.

BACKGROUND

A leakage current measurement device that includes a current detector, which is clamped to a wiring path and detects a leakage current flowing through the wiring path, a voltage detector, which detects an alternating voltage applied to the wiring path, and a processor, which calculates an active leakage current Ior, is known. For example, see Patent Literature (PTL) 1.

CITATION LIST

Patent Literature

PTL 1: JP 2009-198282 A

SUMMARY

In three-phase different capacity connection with R, S, and T phases with the midpoint of the R and S phases being grounded, when a leakage current is detected by a current detector to which three-phase wirings are clamped together, the phase of a capacitance component of a leakage current in the R phase coincides with the phase of a resistance component of a leakage current in the T phase. Also, the phase of a capacitance component of the leakage current in the T phase coincides with the phase of a resistance component of a leakage current in the S-phase.

In this case, the magnitude of a resistance component of a leakage current in each phase cannot be calculated based on the leakage current measured by clamping the three-phase wirings together. In other words, the insulation resistances of the three-phase different capacity connection cannot be measured on live wires. However, measuring the insulation resistances of the three-phase different capacity connection with a power failure increases a workload. It is required to realize the measurement of the insulation resistances of the three-phase different capacity connection on live wires.

It would be helpful to provide a measurement method, a measurement device, and a measurement system that can realize the measurement of the insulation resistances of three-phase different capacity connection on live wires.

A measurement method according to some embodiments includes:

acquiring a three-phase leakage current measured by clamping wirings for three phases in three-phase different capacity connection;
acquiring a single-phase leakage current measured by clamping wirings for two phases whose midpoint being grounded, of the three phases in the three-phase different capacity connection;
calculating, based on the three-phase leakage current and the single-phase leakage current, a resistance component of a leakage current flowing through a wiring for each of the three phases in the three-phase different capacity connection; and
outputting a measurement result of the resistance component of the leakage current flowing through the wiring for each of the three phases in the three-phase different capacity connection.

By measuring each of the three-phase leakage current and the single-phase leakage current by clamping the wirings, the resistance components of the leakage currents in a circuit with the three-phase different capacity connection can be measured on live wires. Measuring the resistance components of the leakage currents in the circuit with the three-phase different capacity connection on live wires eliminates the need for a power failure to measure the resistance components of the leakage currents in the circuit with the three-phase different capacity connection. As a result, a workload for measuring the resistance components of the leakage currents in the circuit with the three-phase different capacity connection is reduced.

In the measurement method according to an embodiment, the acquiring of the three-phase leakage current and the acquiring of the single-phase leakage current may be performed in parallel. The acquisition of the three-phase leakage current and the single-phase leakage current in parallel can reduce the effects of changes in the leakage currents over time.

A measurement device according to some embodiments is configured to:

acquire a three-phase leakage current measured by clamping wirings for three phases in three-phase different capacity connection together, and a single-phase leakage current measured by clamping wirings for two grounded phases whose midpoint being grounded, of the three phases in the three-phase different capacity connection; calculate, based on the three-phase leakage current and the single-phase leakage current, a resistance component of a leakage current flowing through a wiring for each of the three phases in the three-phase different capacity connection; and output a measurement result of the resistance component of the leakage current flowing through the wiring for each of the three phases in the three-phase different capacity connection.

By measuring each of the three-phase leakage current and the single-phase leakage current by clamping the wirings, the resistance components of the leakage currents in a circuit with the three-phase different capacity connection can be measured on live wires. Measuring the resistance components of the leakage currents in the circuit with the three-phase different capacity connection on live wires eliminates the need for a power failure to measure the resistance components of the leakage currents in the circuit with the three-phase different capacity connection. As a result, a workload for measuring the resistance components of the leakage currents in the circuit with the three-phase different capacity connection is reduced.

The measurement device according to an embodiment may include a measurement unit that functions as at least one of a three-phase leakage current measurement unit, which is configured to clamp the wirings for the three phases in the three-phase different capacity connection together, or a single-phase leakage current measurement unit, which is configured to clamp the wirings for the two grounded phases.

The measurement device according to an embodiment may include both of the three-phase leakage current measurement unit and the single-phase leakage current measurement unit, as the measurement unit.

The provision of the measurement unit in the measurement device allows the measurement device alone to measure the resistance components of the leakage currents in the circuit with the three-phase different capacity connection.

A measurement system according to some embodiments includes the above-described measurement device as each of first and second measurement devices. A measurement unit of the first measurement device functions as the three-phase leakage current measurement unit. A measurement unit of the second measurement device functions as the single-phase leakage current measurement unit. A processor of any one of the first measurement device or the second measurement device calculates a resistance component of a leakage current flowing through a wiring for each of the three phases in the three-phase different capacity connection.

The measurement system can be configured with general purpose measurement devices each of which includes only one measurement unit. The use of the general purpose measurement devices can reduce the cost of the measurement devices.

The measurement method, the measurement device, and the measurement system according to the present disclosure can realize the measurement of the insulation resistances of the three-phase different capacity connection on live wires.

BRIEF DESCRIPTION OF THE DRAWINGS

In the accompanying drawings:

FIG. 1 is a schematic diagram of a method according to a comparative example;
FIG. 2 is a vector diagram of a resistance measured by the method according to the comparative example;
FIG. 3 is a schematic diagram illustrating an example of a measurement device according to an embodiment of the present disclosure and an example of a circuit of three-phase different capacity connection to be measured;
FIG. 4A is a vector diagram illustrating an example of a measurement result of a three-phase leakage current;
FIG. 4B is a vector diagram illustrating an example of a measurement result of a single-phase leakage current;
FIG. 4C is a vector diagram in which the measurement results of FIG. 4A and FIG. 4B are superimposed;
FIG. 5 is a schematic diagram illustrating an example of the configuration of the measurement device;
FIG. 6 is a schematic diagram illustrating an example of the configuration of the measurement device in which a second measurement unit is connected via wireless communication;
FIG. 7 is a schematic diagram illustrating an example of the configuration of the measurement device in which no second measurement unit is provided;
FIG. 8 is a schematic diagram illustrating an example of the configuration of a measurement system with a first measurement device and a second measurement device; and

FIG. 9 is a flowchart illustrating an example of the procedure of a measurement method according to an embodiment of the present disclosure.

DETAILED DESCRIPTION

Embodiments of the present disclosure will be described in contrast to a comparative example.

(Comparative Example)

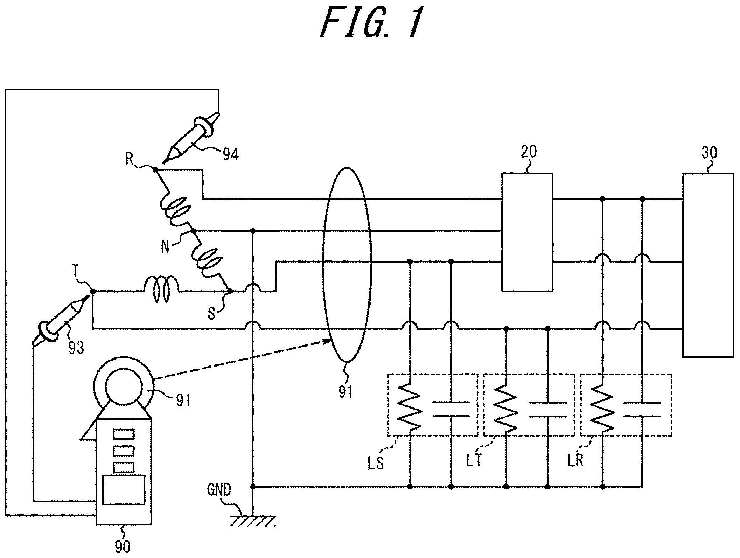

A method according to the comparative example is a method of measuring an insulation resistance in a circuit with three-phase different capacity connection as illustrated in FIG. 1. The circuit with the three-phase different capacity connection has a three-phase load 30, which receives power from three phases, i.e., R, S, and T phases, and a single-phase load 20, which receives power from two phases, i.e., the R and S phases. The midpoint N of the R and S phases is connected to a ground point, which is represented as GND. The circuit with the three-phase different capacity connection illustrated in FIG. 1 is open-delta connection in which the R and T phases are not connected.
An insulation resistance between a wiring for each of the R, S, and T phases and the ground point, which is represented as GND, is represented by an equivalent circuit that includes a resistor and a capacitor connected in parallel between the wiring for each phase and the ground point. The equivalent circuits for leakage currents in the R, S, and T phases are represented as LR, LS, and LT, respectively. A leakage current occurs from the wiring for each of the R, S, and T phases to the ground point through the insulation resistance. The insulation resistance in each phase is measured to identify a wiring in which a leakage current occurs.
In the method according to the comparative example, the insulation resistances of wirings for the respective phases are measured using a measurement device 90. The measurement device 90 has a measurement unit 91 that is configured to clamp the wirings. In the method according to the comparative example, the measurement unit 91 clamps four wirings for the R, S, T, and N phases together. The measurement device 90 can thereby measure the magnitude and phase of a resultant current that combines the magnitude and phases of currents flowing through the four wirings for the R, S, T, and N phases. Also, the measurement device 90 includes a probe 93, which measures the phase of a voltage in the T phase, and a probe 94, which measures the phase of a voltage in the R phase, and therefore can measure the phases of the voltages in the T and R phases.

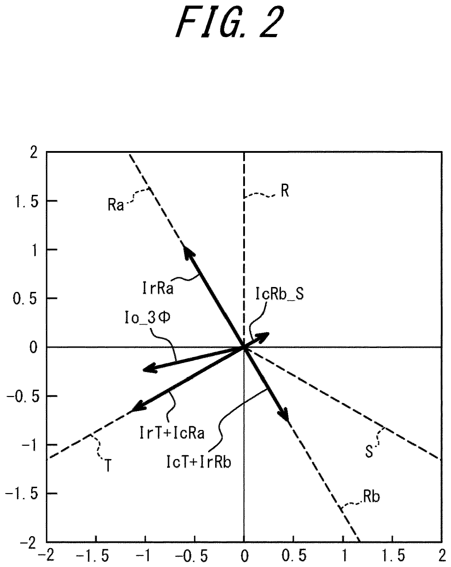

FIG. 2 illustrates a vector diagram of a current measured using the measurement device 90. In FIG. 2, the horizontal axis represents the real part. The vertical axis represents the imaginary part. The dashed lines represented by R, S, and T correspond to the phases of three-phase alternating voltage input to the R, S, and T phases, respectively. The dashed lines represented by Ra and Rb correspond to the phases of the R and S phases relative to the grounded N point in the three-phase different capacity connection, expressed with respect to the phase of the T phase. In the three-phase different capacity connection, vectors in the Ra and Rb phases and a vector in the T phase are in an orthogonal relationship.
In FIG. 2, the magnitude and phase of the current measured by the measurement unit 91 are represented as a vector Io_3Φ. The vector Io_3Φ is a vector of a resultant current that combines vectors of leakage currents flowing through the equivalent circuits of the insulation resistances in the wirings for the respective phases. A current of a resistance component in each phase is represented as Ir. A current of a capacitance component in each phase is represented as Ic. The vectors illustrated in FIG. 2 represent the following currents.

IrRa: Current of a resistance component flowing in the Ra phase
IcRa: Current of a capacitance component flowing in the Ra phase
IrRb: Current of a resistance component flowing in the Rb phase
IcRb_S: Current of a capacitance component flowing in the Rb phase
IrT: Current of a resistance component flowing in the T phase
IcT: Current of a capacitance component flowing in the T phase

Here, due to the orthogonal relationship between the vectors of the Ra and Rb phases and the vector of the T phase, the phase of the current of the capacitance component flowing in the Ra phase coincides with the phase of the current of the resistance component flowing in the T phase. Also, the phase of the current of the capacitance component flowing in the T phase coincides with the phase of the current of the resistance component flowing in the Rb phase. As a result, in the method according to the comparative example, a current of a resistance component in each phase cannot be calculated.
As described above, according to the method of the comparative example, in the circuit with the three-phase different capacity connection, the resistance components cannot be measured on live wires. Therefore, the resistance components are measured using an insulation resistance meter with a power failure. However, there is a problem that the measurement of the resistance components with a power failure causes a large workload.

A measurement method and a measurement device that can realize the measurement of the resistance components on live wires in the circuit with the three-phase different capacity connection will be described below.

(Embodiments of Present Disclosure)

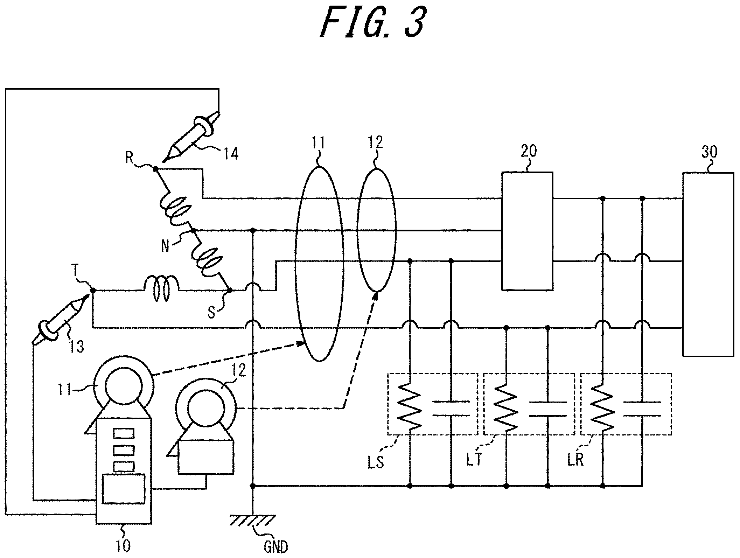

As illustrated in FIG. 3, a measurement device 10 according to an embodiment has a first measurement unit 11, a second measurement unit 12, and probes 13 and 14.

The measurement device 10 measures a current flowing in respective phases of a circuit with three-phase different capacity connection. The circuit with the three-phase different capacity connection to be measured has a three-phase load 30, which receives power from three phases, i.e., R, S, and T phases, and a single-phase load 20, which receives power from two phases i.e., the R and S phases. The midpoint N of the R and S phases is connected to a ground point, which is represented as GND. The circuit with the three-phase different capacity connection illustrated in FIG. 3 has open-delta connection in which the R and T phases are not connected. The measurement device 10 according to the present embodiment can measure resistance components of leakage currents in the open-delta connection circuit illustrated in FIG. 3. The measurement device 10 can also measure resistance components of leakage currents in a delta connection circuit, in which the R and T phases are connected in the circuit illustrated in FIG. 3.

An insulation resistance between a wiring for each of the R, S, and T phases and the ground point, which is represented as GND, is represented by an equivalent circuit that includes a resistor and a capacitor connected in parallel between the wiring for each phase and the ground point. The equivalent circuits for leakage currents in the R, S, and T phases are represented as LR, LS, and LT, respectively. A leakage current occurs from the wiring for each of the R, S, and T phases to the ground point through the insulation resistance. The insulation resistance in each phase is measured to identify a wiring in which a leakage current occurs.

The first measurement unit 11 and the second measurement unit 12 of the measurement device 10 are configured to clamp wirings. The first measurement unit 11 clamps four wirings for the R, S, T, and N phases together. Therefore, the measurement device 10 can measure, by the first measurement unit 11, the magnitude and phase of a resultant current that combines the magnitude and phases of currents flowing through the four wirings for the R, S, T, and N phases. The resultant current that combines the currents flowing through the four wirings for the R, S, T, and N phases is equivalent to a current that combines leakage currents flowing through wirings for three phases, i.e., the R, S, and T phases, and is also referred to as a three-phase leakage current. In other words, the first measurement unit 11 can measure the three-phase leakage current.

The second measurement unit 12 clamps three wirings for the R, S, and N phases. Therefore, the measurement device 10 can measure, by the second measurement unit 12, the magnitude and phase of a resultant current that combines the magnitude and phases of currents flowing through the three wirings for the R, S, and N phases. The resultant current that combines the currents flowing through the three wirings for the R, S, and N phases is equivalent to a current that combines currents flowing through wirings for two phases, i.e., the R and S phases, and is also referred to as a single-phase leakage current. In other words, the second measurement unit 12 can measure the single-phase leakage current.

The first measurement unit 11 and the second measurement unit 12 may be interchangeable. That is, the first measurement unit 11 may measure the single-phase leakage current and the second measurement unit 12 may measure the three-phase leakage current. The first measurement unit 11 and the second measurement unit 12 are also referred to simply as measurement units when there is no need to be distinguished. The measurement units may have at least one of the function of measuring the three-phase leakage current or the function of measuring the single-phase leakage current. The measurement unit is also referred to as a three-phase leakage current measurement unit when measuring the three-phase leakage current. The measurement unit is also referred to as a single-phase leakage current measurement unit when measuring the single-phase leakage current. The measurement units may function as at least one of the three-phase leakage current measurement unit or the single-phase leakage current measurement unit.

The measurement device 10 measures, by the probe 13, the phase of a voltage in the T phase, and measures, by the probe 14, the phase of a voltage in the R phase.

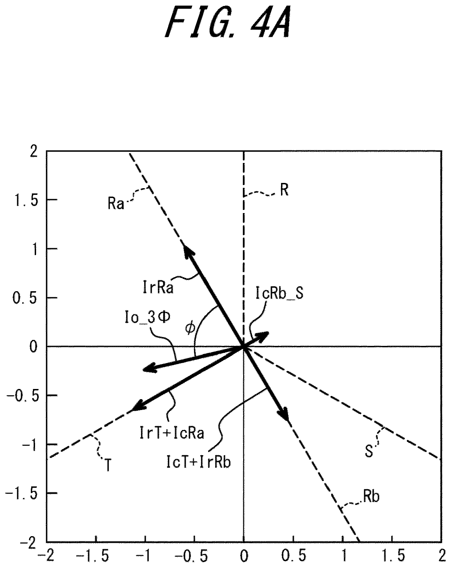

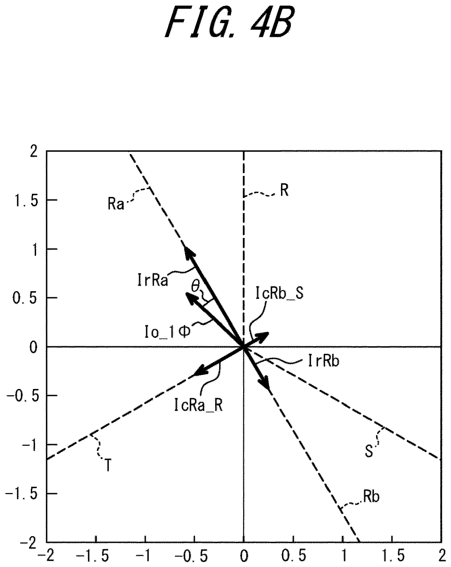

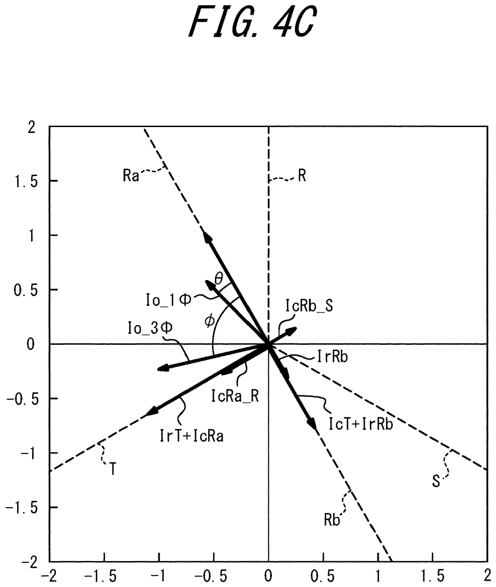

FIG. 4A illustrates a vector diagram of the current measured by the measurement device 10 using the first measurement unit 11. FIG. 4B illustrates a vector diagram of the current measured by the measurement device 10 using the second measurement unit 12. FIG. 4C illustrates a vector diagram in which measurement results illustrated in FIGS. 4A and 4B are superimposed. In FIGS. 4A, 4B, and 4C, the horizontal axis represents the real part. The vertical axis represents the imaginary part. The dashed lines represented by R, S, and T correspond to the phases of three-phase alternating voltage input to the R, S, and T phases, respectively. The dashed lines represented by Ra and Rb correspond to the phases of the R and S phases relative to the grounded N point in the three-phase different capacity connection, expressed with respect to the phase of the T phase. In the three-phase different capacity connection, vectors in Ra and Rb phases and a vector in the T phase are in an orthogonal relationship.

In FIG. 4A, the magnitude and phase of the three-phase leakage current measured by the first measurement unit 11 are expressed as a vector Io_3Φ. The vector Io_3Φ is a vector that combines vectors of leakage currents flowing through the equivalent circuits of the insulation resistances in the wirings for the respective phases. A current of a resistance component in each phase is represented as Ir. A current of a capacitance component in each phase is represented as Ic. The vectors illustrated in FIG. 4A represent the following currents.

IrRa: Current of a resistance component flowing in the Ra phase
IcRa: Current of a capacitance component flowing in the Ra phase
IrRb: Current of a resistance component flowing in the Rb phase
IcRb_S: Current of a capacitance component flowing in the Rb phase
IrT: Current of a resistance component flowing in the T phase
IcT: Current of a capacitance component flowing in the T phase

In FIG. 4A, $\phi$ represents the phase angle of the vector Io_3Φ, which represents the three-phase leakage current measured by the first measurement unit 11, with respect to the Ra phase.

In FIG. 4B, the magnitude and phase of the single-phase leakage current measured by the second measurement unit 12 are expressed as a vector Io_1Φ. The vector Io_1Φ is a vector that combines vectors of leakage currents flowing through the equivalent circuits of the insulation resistances in the wirings for the respective phases. A current of a resistance component in each phase is represented as Ir. A current of a capacitance component in each phase is represented as Ic. The vectors illustrated in FIG. 4B represent the following currents.

IrRa: Current of a resistance component flowing in the Ra phase
IcRa_R: Current of a capacitance component flowing in the Ra phase
IrRb: Current of a resistance component flowing in the Rb phase
IcRb_S: Current of a capacitance component flowing in the Rb phase

In FIG. 4B, $\theta$ represents the phase angle of the vector Io_1Φ, which represents the single-phase leakage current measured by the second measurement unit 12, with respect to the Ra phase.

With reference to FIG. 4C, in which the vectors of the respective components illustrated in FIGS. 4A and 4B are superimposed, a measurement method of the resistance components of the leakage currents flowing in the circuit with the three-phase different capacity connection will be described.

First, assume that resistance components of leakage currents in the R and S phases are represented by Ior_RS. Ior_RS is calculated by the following Equation (1).

$$\text{Ior\_RS} = \text{Io\_1}\Phi \times \cos\theta \qquad (1)$$

Here, when Ior_RS > 0, then Ior_R, which is a resistance component of a leakage current in the R phase, is equal to Ior_RS. When Ior_RS < 0, then Ior_S, which is a resistance component of a leakage current in the S phase, is equal to Ior_RS.

Next, assume that a resistance component of a leakage current in the T phase is represented by Ior_T. Ior_T is calculated by the following Equation (2).

$$\text{Ior\_T} = \text{Io\_3}\Phi \times \cos\phi - \text{Io\_1}\Phi \times \sin\theta \qquad (2)$$

Since the phases of the resistance components of the leakage currents in the R and S phases and the phase of the resistance component of the leakage current in the T phase are in an orthogonal relationship, Ior, which is the combined value of the resistance components of the leakage currents in the respective phases in the circuit with the three-phase different capacity connection, is calculated by the following Equation (3).

$$\text{Ior} = \text{SQRT} \left(\text{Ior\_RS}^2 + \text{Ior\_T}^2\right) \qquad (3)$$

Where SQRT(.) represents a square root. In other words, Equation (3) is a formula for calculating the square root of the sum of the squares of the resistance components of the leakage currents in the R and S phases and the resistance component of the leakage current in the T phase.

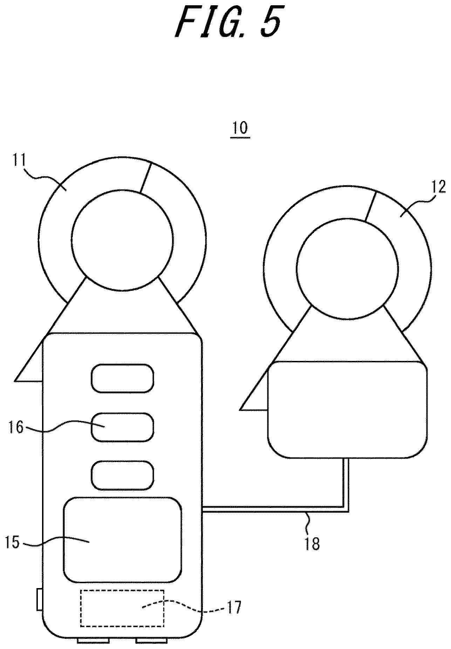

As illustrated in FIG. 5, the measurement device 10 includes a display 15, an operation unit 16, a controller 17, and a communication interface 18, in addition to the first and second measurement units 11 and 12. The measurement device 10 may accept a user operation by the operation unit 16, and acquire, in response to the user operation, measurement results of the first measurement unit 11, the second measurement unit 12, and the probes 13 and 14. The measurement device 10 may perform, by the controller 17, the calculation of Ior, as described above, and display a measurement result of Ior on the display 15. The measurement device 10 may output the measurement result of Ior to another device via the communication interface 18.

The controller 17 may be configured with a processor such as a central processing unit (CPU), or configured with a dedicated circuit such as an application specific integrated circuit (ASIC). The display 15 may be configured with a light emitting device such as a light emitting diode (LED), or configured with any type of display such as a liquid crystal display or plasma display. The operation unit 16 may be configured with a button, key, or the like, or configured with a pointing device such as a mouse or touch panel. The communication interface 18 may be used for communication to acquire the measurement result of the second measurement unit 12. The communication interface 18 may be configured to be able to communicate with another device.

In the measurement device 10 illustrated in FIG. 5, the first measurement unit 11 is configured as a part of a housing that contains the controller 17 and the like, and is connected to the controller 17 inside the housing. The second measurement unit 12 is connected to the controller 17 via the communication interface 18. In the example in FIG. 5, the communication interface 18 connects the second measurement unit 12 to the housing via a communication cable. The controller 17 can acquire, via the communication interface 18, a measurement result of a current by the second measurement unit 12.

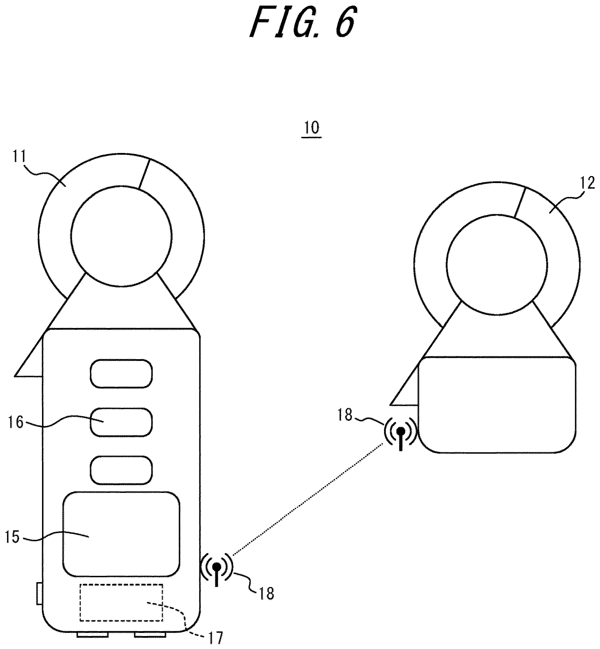

As illustrated in FIG. 6, the communication interface 18 may be configured to connect the second measurement unit 12 via wireless communication. The connection of the second measurement unit 12 via the wireless communication eliminates the need for the measurement device 10 to be equipped with a communication cable. The fact that the measurement device 10 does not have a communication cable facilitates handling when the second measurement unit 12 is clamped to the wirings of the circuit to be measured.

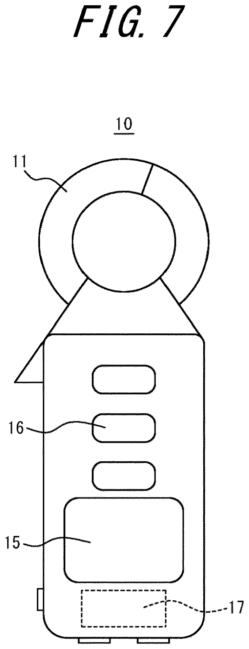

As illustrated in FIG. 7, the measurement device 10 may not necessarily include the second measurement unit 12. In other words, the measurement device 10 may include only one measurement unit. In this case, the measurement device 10 performs a step of measuring, by the first measurement unit 11, the three-phase leakage current by clamping the four wirings of the R, S, T, and N phases and a step of measuring, by the first measurement unit 11, the single-phase leakage current by clamping the three wirings of the R, S, and N phases, with staggering the time. Either of the steps of measuring the three-phase leakage current or the single-phase leakage current may be performed first. With the use of the three-phase leakage current and the single-phase leakage current obtained in each step, the measurement device 10 can calculate the resistance components of the leakage currents in the circuit with the three-phase different capacity connection.

Even when the measurement device 10 does not include the second measurement unit 12 as illustrated in FIG. 7, the measurement method according to this embodiment can be performed by differing the wirings to be clamped in the two measurement steps. Therefore, the measurement method according to this embodiment can be performed using the measurement device 10 that includes only the first measurement unit 11, only by changing software. In other words, the measurement method according to this embodiment can be performed using a general purpose measurement device 10 that includes only the first measurement unit 11, without preparing the measurement device 10 that includes both the first measurement unit 11 and the second measurement unit 12. The use of the general purpose measurement device 10 can reduce the cost of the measurement device 10.

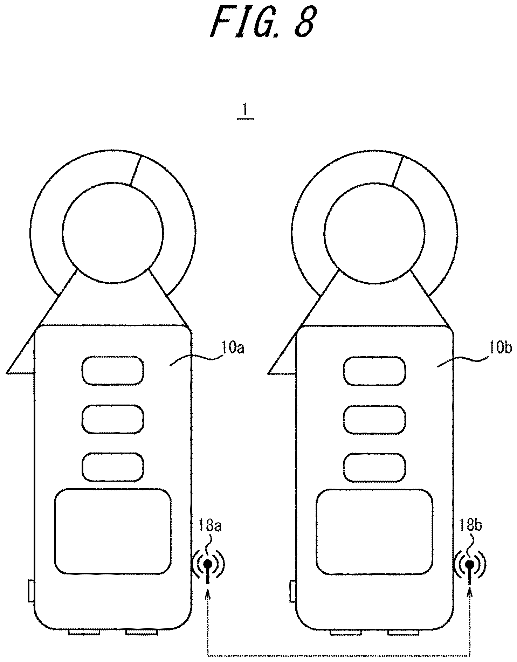

As illustrated in FIG. 8, the measurement method according to this embodiment may be performed by a measurement system 1 that includes two measurement devices 10a and 10b. The measurement devices 10a and 10b may be configured identically to the measurement device 10 described above or may differ in some parts.

The measurement devices 10a and 10b include communication interfaces 18a and 18b, respectively. The communication interfaces 18a and 18b are configured to be able to communicate with wired or wireless communication.

In the measurement system 1, one of the measurement device 10a or 10b functions as a master device. When the measurement device 10a functions as the master device, the measurement device 10b functions as a slave device. The measurement device 10a is also referred to as a first measurement device. The measurement device 10b is also referred to as a second measurement device. In this case, a measurement unit of the measurement device 10a measures one of the three-phase leakage current or the single-phase leakage current. A measurement unit of the measurement device 10b measures the other of the three-phase leakage current or the single-phase leakage current. A controller 17 of the measurement device 10a can acquire measurement results of the three-phase leakage current and the single-phase leakage current by acquiring measurement results of the measurement devices 10a and 10b, and can calculate the resistance components of the leakage currents in the circuit with the three-phase different capacity connection.

The measurement system 1 illustrated in FIG. 8 can be configured with a general purpose measurement device 10 that includes only the first measurement unit 11. The use of the general purpose measurement device 10 can reduce the cost of the measurement device 10.

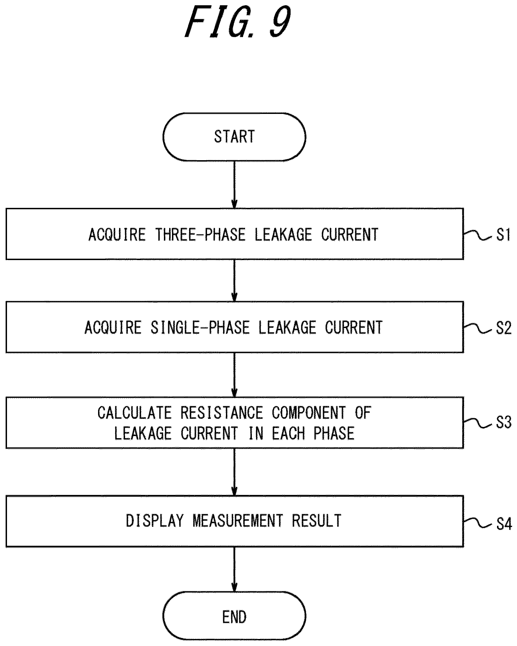

The controller 17 of the measurement device 10 may perform a measurement method including the procedure illustrated in the flowchart in FIG. 9. The measurement method may be realized as a measurement program to be executed by the processor that makes up the controller 17. The measurement program may be stored in a non-transitory computer readable medium.

The controller 17 acquires a three-phase leakage current (step S1). The controller 17 acquires a single-phase leakage current (step S2). Based on the three-phase leakage current and the single-phase leakage current, the controller 17 calculates a resistance component of a leakage current in each of the R, S, and T phases of the three-phase different capacity connection (step S3). The controller 17 also calculates Ior, which is a resultant value that combines the resistance components of the leakage currents in the respective phases in the circuit with the three-phase different capacity connection. The controller 17 displays a measurement result of Ior on the display 15 (step S4). The controller 17 may output the measurement result of Ior to another device. After the execution of step S4, the controller 17 terminates the execution of the procedure in the flowchart in FIG. 9.

(Summary)

As described above, according to the measurement method and the measurement device 10 of this embodiment, the resistance components of the leakage currents in the circuit with the three-phase different capacity connection are calculated based on the currents measured by clamping the wirings. Therefore, the resistance components of the leakage currents in the circuit with the three-phase different capacity connection can be measured on live wires. In other words, a power failure is no longer required to measure the resistance components of the leakage currents in the circuit with the three-phase different capacity connection. As a result, a workload for measuring the resistance components of the leakage currents in the circuit with the three-phase different capacity connection is reduced.

The measurement device 10 may include both of the three-phase leakage current measurement unit and the single-phase leakage current measurement unit. In this case, the measurement device 10 can measure the three-phase leakage current and the single-phase leakage current in parallel. Measuring the three-phase leakage current and the single-phase leakage current in parallel can reduce the effects of changes in the leakage currents over time.

The measurement device 10 may include only one measurement unit that functions as at least one of the three-phase leakage current measurement unit or the single-phase leakage current measurement unit. In this case, the resistance components of the leakage currents in the circuit with the three-phase different capacity connection can be measured on live wires using the measurement device 10 that is configured for a general purpose. The use of the measurement device 10 configured for a general purpose requires no special device. As a result, the cost of the device can be reduced.

Since the measurement device 10 includes the measurement unit, the resistance components of the leakage currents in the circuit with the three-phase different capacity connection can be measured by the measurement device 10 alone.

The measurement device 10 may not include the measurement unit. In this case, the controller 17 of the measurement device 10 may acquire the measurement results of the three-phase leakage current and the single-phase leakage current measured by other devices, calculate the resistance components of the leakage currents in the circuit with the three-phase different capacity connection, and output or display the results as measurement results.

In the embodiment described above, the resistance components of the leakage currents are calculated for the circuit with the three-phase different capacity connection in which the midpoint of the R and S phases is grounded. The circuit with the three-phase different capacity connection for which the resistance components of the leakage currents are calculated may be a circuit in which the midpoint of the R and T phases is grounded, or a circuit in which the midpoint of the S and T phases is grounded. In the circuit with the three-phase different capacity connection, the two phases whose midpoint is grounded are also referred to as grounded phases.

In the embodiment described above, the resistance components of the leakage currents are calculated for the circuit with the open-delta three-phase different capacity connection. The circuit with the three-phase different capacity connection for which the resistance components of the leakage currents are to be calculated may be, for example, a circuit with delta connection in which the R and T phases are connected in the circuit illustrated in FIG. 3. In the circuit with the delta connection, a combination of two phases whose midpoint is to be grounded may be selected arbitrarily.

Although the embodiments according to the present disclosure have been described based on the drawings and examples, it should be noted that a person skilled in the art can make various variations or modifications based on the present disclosure. Accordingly, it should be noted that these variations or modifications are included in the scope of the present disclosure. For example, the functions or the like included in each component can be rearranged so as not to be logically inconsistent, and multiple components can be combined into one or divided.

**Claims**

1. A measurement method comprising:

   acquiring a three-phase leakage current measured by clamping wirings for three (R, S, and T) phases in three-phase different capacity connection;

   acquiring a single-phase leakage current measured by clamping wirings for two (R and S) phases whose midpoint (N) being grounded, of the three (R, S, and T) phases in the three-phase different capacity connection;

   calculating, based on the three-phase leakage current and the single-phase leakage current, a resistance component of a leakage current flowing through a wiring for each of the three (R, S, and T) phases in the three-phase different capacity connection; and

   outputting a measurement result of the resistance component of the leakage current flowing through the wiring for each of the three (R, S, and T) phases in the three-phase different capacity connection.

2. The measurement method according to claim 1, wherein the acquiring of the three-phase leakage current and the acquiring of the single-phase leakage current are performed in parallel.

3. A measurement device (10) configured to:

   acquire a three-phase leakage current measured by clamping wirings for three (R, S, and T) phases in three-phase different capacity connection together, and a single-phase leakage current measured by clamping wirings for two (R and S) grounded phases whose midpoint (N) being grounded, of the three (R, S, and T) phases in the three-phase different capacity connection;

   calculate, based on the three-phase leakage current and the single-phase leakage current, a resistance component of a leakage current flowing through a wiring for each of the three (R, S, and T) phases in the three-phase different capacity connection; and

   output a measurement result of the resistance component of the leakage current flowing through the wiring for each of the three (R, S, and T) phases in the three-phase different capacity connection.

4. The measurement device (10) according to claim 3, comprising a measurement unit that functions as at least one of a three-phase leakage current measurement unit (11) configured to clamp the wirings for the three (R, S, and T) phases in the three-phase different capacity connection together, or a single-phase leakage current measurement unit (12) configured to clamp the wirings for the two (R and S) grounded phases.

5. The measurement device (10) according to claim 4, comprising both of the three-phase leakage current measurement unit (11) and the single-phase leakage current measurement unit (12), as the measurement unit.

6. A measurement system (1) comprising the measurement device (10) according to claim 4 as each of first and second measurement devices,

   wherein

   a measurement unit of the first measurement device functions as the three-phase leakage current measurement unit (11),

   a measurement unit of the second measurement device functions as the single-phase leakage current measurement unit (12), and

   a processor of any one of the first measurement device or the second measurement device calculates a resistance component of a leakage current flowing through a wiring for each of the three (R, S, and T) phases in the three-phase different capacity connection.

# FIG. 1

EP 4 450 991 A1

## FIG. 2

11

# FIG. 3

# FIG. 4A

# FIG. 4B

# FIG. 4C

# FIG. 5

# FIG. 6

# FIG. 7

# FIG. 8

# FIG. 9

```
          ╭─────────────╮
          │    START    │
          ╰─────────────╯
                 │
                 ▼
   ┌───────────────────────────────────────┐
   │ ACQUIRE THREE-PHASE LEAKAGE CURRENT    │──∿ S1
   └───────────────────────────────────────┘
                 │
                 ▼
   ┌───────────────────────────────────────┐
   │ ACQUIRE SINGLE-PHASE LEAKAGE CURRENT   │──∿ S2
   └───────────────────────────────────────┘
                 │
                 ▼
   ┌───────────────────────────────────────┐
   │ CALCULATE RESISTANCE COMPONENT OF      │──∿ S3
   │ LEAKAGE CURRENT IN EACH PHASE          │
   └───────────────────────────────────────┘
                 │
                 ▼
   ┌───────────────────────────────────────┐
   │ DISPLAY MEASUREMENT RESULT             │──∿ S4
   └───────────────────────────────────────┘
                 │
                 ▼
          ╭─────────────╮
          │     END     │
          ╰─────────────╯
```

Europäisches
Patentamt

European
Patent Office

Office européen
des brevets

# EUROPEAN SEARCH REPORT

Application Number

EP 24 16 6518

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2011 153910 A (PATOKKUSU JAPAN KK) 11 August 2011 (2011-08-11) * paragraphs [0045] - [0049]; figures 1-5 * | 1-6 | INV. G01R31/52 |
| A | CN 110 687 478 A (XIXIA POWER SUPPLY COMPANY STATE GRID HENAN ELECTRIC POWER COMPANY) 14 January 2020 (2020-01-14) * figure 2 * | 1-6 | |
| A | JP 2002 125313 A (KANSAI DENKI HOAN KYOKAI) 26 April 2002 (2002-04-26) * the whole document * | 1-6 | |

TECHNICAL FIELDS SEARCHED (IPC)

G01R

The present search report has been drawn up for all claims

| Place of search | Date of completion of the search | Examiner |
|---|---|---|
| Munich | 23 August 2024 | Schindler, Martin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 16 6518

This annex lists the patent family members relating to the patent documents cited in the above-mentioned European search report.
The members are as contained in the European Patent Office EDP file on
The European Patent Office is in no way liable for these particulars which are merely given for the purpose of information.

23-08-2024

| Patent document cited in search report | | Publication date | Patent family member(s) | | Publication date |
|---|---|---|---|---|---|
| JP 2011153910 | A | 11-08-2011 | JP | 5544517 B2 | 09-07-2014 |
| | | | JP | 2011153910 A | 11-08-2011 |
| CN 110687478 | A | 14-01-2020 | NONE | | |
| JP 2002125313 | A | 26-04-2002 | JP | 3405407 B2 | 12-05-2003 |
| | | | JP | 2002125313 A | 26-04-2002 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2009198282 A